# EUROPÄISCHE PATENTSCHRIFT

(11) **EP 0 361 211 B1**
(45) Veröffentlichungstag und Bekanntmachung des Hinweises auf die Patenterteilung: **26.01.1994**
(21) Anmeldenummer: 89116976.5
(22) Anmeldetag: 13.09.1989
(51) Int. Cl.: H03K 17/08

(54) **Schutzschaltung für einen Leistungshalbleiterbaustein**
Protection circuit for a power semiconductor unit
Circuit de protection pour une unité semi-conductrice de puissance

(30) Priorität: 28.09.1988 DE 3832917; 29.03.1989 DE 3910188
(43) Veröffentlichungstag der Anmeldung: 04.04.1990
(73) Patentinhaber: SIEMENS AKTIENGESELLSCHAFT, 80333 München (DE)
(72) Erfinder: Brajder, Antonio, Dipl.-Ing., D-8520 Erlangen (DE); Hügel, Harald, Dipl.-Ing., D-8520 Erlangen (DE); Franke, Ralf-Michael, Dipl.-Ing., D-8520 Erlangen (DE); Schikor, Joachim, Dipl.-Ing., D-8525 Uttenreuth (DE)

(56) Entgegenhaltungen:
- EP-A- 0 190 925
- DE-A- 3 743 453
- GB-A- 2 082 003
- PATENT ABSTRACTS OF JAPAN Band 9, nr.251 (E-348)(1974) 8 October 1985& JP-A-60100823
- IBM TECHNICAL DISCLOSURE BULLETIN Band 18, nr.10 März 1967, seiten 3236-3237, New York US; S.D.Malaviya: "Self-protected totem pole driver"
- ELEKTRONIK Heft 25, 1980, seiten 45-49, DE; K.Rischmueller: "Pulsgesteuerte Treiberstufen für Brückenschaltungen"

## Beschreibung

Die Erfindung bezieht sich auf eine Schutzschaltung für einen Schalttransistor nach dem Oberbegriff des Anspruchs 1 insbesondere für einen IGBT-Transistor.

Aus der Zeitschrift "Elektronik", 1980, Heft 25, Seiten 45 bis 49 ist eine Schutzschaltung für einen Schalttransistor mit einer Abschalteinrichtung für Ansteuerimpulse des Schalttransistors bekannt. Dabei wird die Abschalteinrichtung von einem Komparator angesteuert, der eine Spannung am Schalttransistor mit einer Referenzspannung vergleicht und die Ansteuerimpulse bei Überlastung des Schalttransistors ausschaltet. Mit einer derartigen Schutzschaltung wird der Schalttransistor auf Entsättigung überwacht, d.h., es wird geprüft, ob eine Kollektor-Emitter-Spannung den bei gesättigtem Transistor auftretenden Wert übersteigt. Damit kann der Schalttransistor gegen Kurzschluß und Überlast geschützt werden. Bei der bekannten Schaltung wird also die an der Kollektor-Emitter-Strecke des Schalttransistors anstehende Spannung in einem Komparator mit einer dem Sättigungswert entsprechenden Referenzspannung verglichen und die Ansteuerimpulse werden abgeschaltet, wenn die Kollektor-Emitter-Spannung des Schalttransistors den Sättigungswert überschreitet.

Eine weitere Schutzschaltung für Schalttransistoren der eingangs genannten Art ist aus der Zeitschrift "IBM-Technical Disclosure Bulletin", Band 18, Nr. 10, Seiten 3236 bis 3237 bekannt. Bei dieser Schutzschaltung wird die Basis-Emitter-Spannung des Schalttransistors mit einer Referenzspannung eines vergleichenden Mittels verglichen. Als vergleichendes Mittels ist eine Schottky-Diode vorgesehen, deren Anode mit der Basis des Schalttransistors und deren Kathode mit dem Kollektor des Transistors verbunden sind. Beim Ansteigen der Basis-Emitter-Spannung des Schalttransistors wird die Schottky-Diode leitend und führt den überschüssigen Basisstrom des Schalttransistors über einen Transistor und einen Widerstand zum Ausgang.

Mit diesen beiden Schaltungen wird im Falle eines Kurzschlusses der Kurzschlußstrom abgeschaltet oder aktiv begrenzt. Da bei Schalttransistoren bzw. Hochvolttransistoren die volle Ausnutzung der Kurzschlußfestigkeit dadurch erschwert wird, daß der optimale Basis-Ausräumstrom zum Abschalten des Schalttransistors bzw. Hochvolttransistors im Kurzschlußfall nicht mit dem optimalen Basis-Ausräumstrom zum Abschalten unter Nenn-Betriebsbedingungen übereinstimmt, wird als Kompromiß ein mittlerer Basis-Ausräumstrom gewählt.

Die gleiche Abschaltproblematik ist auch auf moderne IGBT-Transistoren (IGBT = Insulated-Gate-Bipolar-Transistor) anwendbar. Bie diesen Leistungshalbleitern ist eine MOSFET-Eingangsstufe mit einer bipolaren Ausgangsstufe verbunden. Die Funktionsweise dieser Leistungshalbleiter ist beispielsweise in der Druckschrift "ABB, Abschaltbare Leistungshalbleiter, Technische Information anläßlich einer Fachpressetagung am 06.06.1988 in München" beschrieben.

Der Erfindung liegt nun die Aufgabe zugrunde, die Schutzschaltung der eingangs genannten Art dahingehend zu verbessern, daß der Schalttransistor sowohl im Kurzschlußfall als auch unter den Nenn-Betriebsbedingungen mit einem jeweiligen Basis-Ausräumstrom angesteuert wird, so daß die Kurzschlußfestigkeit des Schalttransistors immer voll ausgenutzt werden kann. Außerdem liegt der Erfindung die Aufgabe zugrunde, eine Schutzschaltung der eingangs genannten Art dahingehend zu verbessern, daß ein Leistungshalbleiterbaustein, insbesondere ein IGBT-Transistor, im Kurzschlußfall eine angepaßte Abschaltung erfährt, ohne daß der Leistungshalbleiter oder die von diesem angesteuerten Elemente durch Überspannungen gefährdet werden.

Der Patentanspruch 1 geht mit seinem Oberbegriff von der Entgegenhaltung GB-A-2 082 003 aus. Bei dieser Entgegenhaltung sind ein Einschaltpfad sowie zwei Ausschaltpfade für einen Transistor 13 vorgesehen. Welcher der Ausschaltpfade verwendet wird, wird durch eine Kollektor-Emitter-Spannungs-Überwachungsschaltung vorgegeben.

Die Aufgabe wird erfindungsgemäß durch die im kennzeichnenden Teil des Anspruchs 1 enthaltenen Merkmale gelöst. Die Basis des Schalttransistors ist mit einer zweiten negativen Stromquelle verknüpft, deren erzeugte Stromamplitude kleiner ist als die der ersten negativen Stromquelle, und daß ein Steuerglied ist vorgesehen, das eingangsseitig mit der Kollektor-Emitter-Überwachung und ausgangsseitig mit den Stromquellen verbunden ist.

Dadurch, daß die Basis-Emitter-Strecke des Schalttransistors mit zwei negativen Stromquellen versehen ist, deren Amplitudenwerte unterschiedlich sind, kann man die eine negative Stromquelle für den Nenn-Betrieb und die andere negative Stromquelle für den Kurzschlußfall auslegen. Im Nenn-Betrieb bzw. unter normalen Betriebsbedingungen haben die Schalttransistoren - auch Hochvolttransistoren genannt - relativ lange Speicherzeiten, die sich nachteilig auf die Eigenschaften der mit diesen Schalttransistoren ausgerüsteten Geräten, beispielsweise Stromrichter, auswirken. Deshalb muß mit dem höchstmöglichen negativen Basis-Ausräumstrom der Schalttransistor ausgeräumt werden, womit die Speicherzeiten niedrig gehalten werden können.

Wegen sehr hoher Stromdichte im Kurzschlußfall würde eine Ansteuerung des Schalttransistors mit dem negativen Basis-Ausräumstrom für den Nenn-Betriebsfall zu Einschnüreffekten führen, wodurch der Schalttransistor die Abschaltfähigkeit verliert und zerstört wird. Um eine hohe Kurzschlußfestigkeit für den Kurzschlußfall zu erhalten, ist es vorteilhaft, gemäß einem Diagramm "Reverse Bias Safe Operating Area" (Reverse Bias S.O.A.), in dem die Abhängigkeit des Kollektorstromes von der Kollektor-Emitter-Spannung mit dem negativen Basisstrom als Parameter gezeigt wird, den Schalttransistor mit einem relativ niedrigen Basis-Ausräumstrom anzusteuern.

Damit im Kurzschlußfall die Ansteuerimpulse des Nenn-Betriebes nicht zur Basis des Schalttransistors, insbesondere die negativen Ströme, gelangen, ist ein Steuerglied vorgesehen, das die zweite negative Stromquelle freigibt, damit mit einem auf die Kurzschlußfestigkeit im Kurzschlußfall abgestimmten Basis-Ausgangsstrom der Schalttransistor ausgeschaltet werden kann. Damit diese Schaltung unabhängig von einer Überwachungsschaltung des Schalttransistors diesen Schalttransistor immer mit einem ersten bzw. zweiten negativen Strom unter Berücksichtigung der vollen Ausnutzung der Kurzschlußfestigkeit des verwendeten Schalttransistors ausschalten kann, ist das Steuerglied auch von einer Basis-Emitter-Überwachung des Schalttransistors ansteuerbar. Es ist ebenfalls möglich, die Kollektor-Emitter-Überwachung und die Basis-Emitter-Überwachung als eine Baueinheit auszubilden, wobei deren Ausgänge mittels eines ODER-Gatter verknüpft sind.

Eine weitere Lösung der Aufgabe besteht darin, daß zum Auslösen eines Sperrzustandes des Leistungshalbleiterbausteins dessen Steuereingang jeweils über einen von zwei widerstandsbehafteten Pfaden an eine den Leistungshalbleiterbaustein sperrende Spannung schaltbar ist, wobei der Widerstand des ersten Pfades eine für Normalbetrieb ausgelegte Abschaltgeschwindigkeit auslöst, während der Widerstand des zweiten Pfades eine demgegenüber geringere Abschaltgeschwindigkeit für Überlastbetrieb auslöst und wobei die Auswahl der Pfade von der Laststromüberwachungsschaltung getroffen wird.

Zur weiteren Erläuterung der Erfindung wird auf die Zeichnung Bezug genommen, in der ein Ausführungsbeispiel einer Schutzschaltung für einen Schalttransistor nach der Erfindung schematisch veranschaulicht ist.
- FIG 1: zeigt eine Schutzschaltung, in
- FIG 2: ist ein Diagramm "Reverse Bias S.O.A." dargestellt, daß die Abhängigkeit des Kollektorstromes von der Kollektor-Emitter-Spannung mit dem negativen Basisstrom als Parameter zeigt und
- FIG 3: veranschaulicht eine erfindungsgemäße Schutzschaltung für einen IGBT-Transistor, die als Ausgangspunkt für die erfindungsgemäße Schutzschaltung dient.

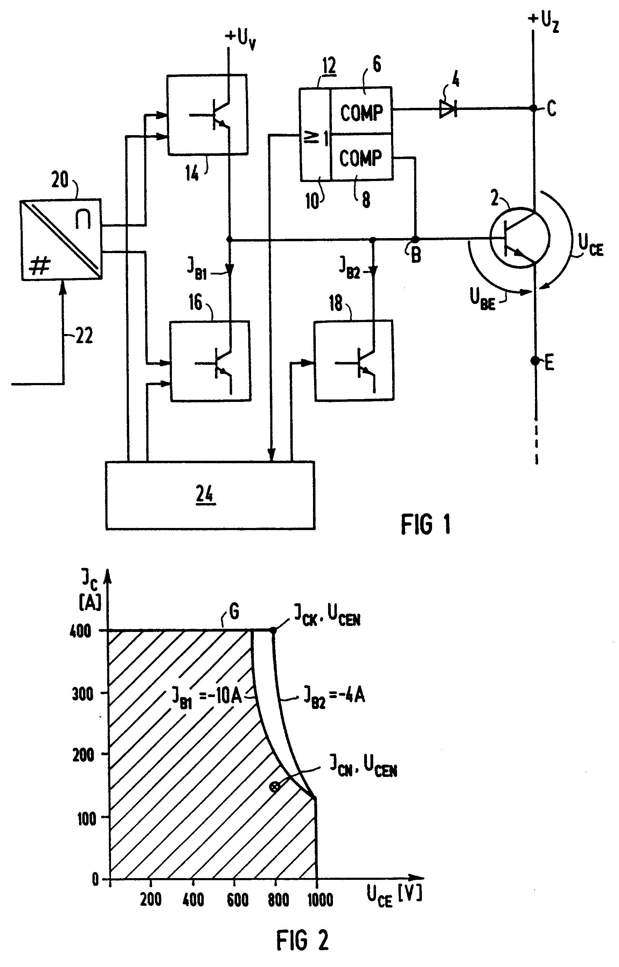

FIG 1 zeigt das schematisiert Grundschaltbild der erfindungsgemäßen Schutzschaltung. Dabei ist ein Schalttransistor 2 bzw. Hochvolttransistor 2 kollektorseitig an eine Versorgungsspannung +U_{Z} angeschlossen. Dieser Schalttransistor 2 kann einer der beiden Schalttransistoren eines Brückenzweiges eines Stromrichters sein, wobei der Emitter E dann mit einem Kollektor des zweiten Schalttransistors des Brückenzweiges verbunden ist. Aus Übersichtlichkeitsgründen ist der zweite Schalttransistor des Brückzweiges bzw. der Stromrichter, bestehend aus mehreren Brückenzweigen nicht dargestellt. Als versorgungsspannungsquelle +U_{Z} kann auch ein den Stromrichter speisender Zwischenkreis vorgesehen sein. Wenn der Schalttransistor 2 einer von beispielsweisen sechs Schalttransistoren eines Stromrichters ist, kann eine Last, die aus Übersichtlichkeitsgründen nicht dargestellt ist, am Kollektor C bzw. am Emitter E des Schalttransistors 2 angeschlossen sein. Über eine Entkopplungsdiode 4 ist eine Kollektor-Emitter-Überwachung 6 mit dem Kollektor G des Schalttransistors 2 verbunden, seine Basis B ist direkt mit einer Basis-Emitter-Überwachung 8 verknüpft. Ausgangsseitig ist die Kollektor-Emitter-Überwachung 6 und die BasisEmitterÜberwachung 8 mittels eines ODER-Gatters 10 miteinander verbunden. Diese beiden Überwachungen 6 und 8 und das ODER-Gatter 10 bilden zusammen eine Baueinheit 12. An der Basis B des Schalttransistors 2 sind außerdem noch eine positive Stromquelle 14, eine erste negative Stromquelle 16 und eine zweite negative Stromquelle 18 angeschlossen. Die positive und die erste negative Stromquelle 14 und 16 werden von einem potentialtrennenden Wandler 20 aktiviert. Als potentialtrennender Wandler 20 ist ein Digital-Analog-Wandler mit Potentialtrennung vorgesehen. Diesem Wandler 20 wird ein Steuersignal mittels einer Leitung 22 aus einer Drehzahl-Regelung bzw. einer übergeordneten Steuerung zugeführt, wobei die Drehzahl-Regelung bzw. die übergeordnete Steuerung aus Übersichtlichkeitsgründen nicht dargestellt ist. Außerdem sind die positive und die erste negative Stromquelle 14 und 16 mit einem Steuerglied 24 verknüpft. Diesem Steuerglied 24 ist ferner auch ein Ausgangssignal des ODER-Gatters 10 der Baueinheit 12 zugeführt. Ausgangsseitig ist das Steuerglied 24 mit der zweiten negativen Stromquelle 18 verknüpft. Als Steuerglied 24 kann beispielsweise eine logische Schalteinrichtung vorgesehen sein, die in Abhängigkeit eines Eingangssignals die positive und erste negative Stromquelle 14 und 16 sperrt und die zweite negative Stromquelle 18 freigibt.

Die Funktion dieser Anordnung wird nachfolgend anhand des Diagramms nach FIG 2 näher erläutert. FIG 2 zeigt die Abhängigkeit des Kollektorstromes I_{C} von der Kollektor-Emitter Spannung U_{CE} mit einem negativen Basisstrom I_{B1}, I_{B2} als Parameter. Dieses Diagramm wird in Datenblättern als "Reverse Bias S.O.A." bezeichnet. Dabei zeigt der schraffierte Bereich einen zulässigen Bereich für Wertepaare I_{C}, U_{CE} bei einem negativen Basisstrom I_{B1}.

Aufgabe der Schutzschaltung ist es, dafür zu sorgen, daß der Schalttransistor 2 den erlaubten schraffierten Bereich für einen vorbestimmten negativen Basisstrom I_{B1}, I_{B2} nicht verläßt. Wenn also bei eingeschaltetem Schalttransistor 2 z.B. durch einen Kurzschluß der Last der Kollektorstrom I_{C} ansteigt, so kann der Schalttransistor 2 nur mit einem negativen Basisstrom I_{B1} bzw. I_{B2} abgeschaltet werden, damit bei gegebener Kollektor-Emitter-Spannung U_{CE} der Schalttransistor 2 nicht zerstört wird.

Für einen Nenn-Betriebszustand sei angenommen, daß die Nenn-Kollektor-Emitter-Spannung U_{CEN} einen Wert von 800 V hat und der Wert des Nenn-Kollektorstromes I_{CN} ungefähr 150 A beträgt. Wenn man nun diesen Schalttransistor 2 im Nenn-Betriebszustand ausschalten möchte, wobei die Speicherzeit des Schalttransistors 2 niedrig geschaltet werden soll, so muß mit einem höchstmöglichen negativen Basisstrom I_{B} der Schalttransistor 2 ausgeräumt werden. Gemäß dem Diagramm bietet sich als Ausräumstrom der negative Basisstrom I_{B1} an, dessen Wert 10 A ist, ohne dabei aus dem schraffierten Bereich zu kommen. Je näher man an die durchgezogene Grenzlinie G kommt, umso höher ist die Ausnutzung der Kurzschlußfestigkeit.

Tritt nun ein Kurzschluß an einer Last auf, so steigt der Kollektorstrom I_{CK} auf ein Mehrfaches des Nenn-Kollektorstromes I_{CN} an. Es wird angenommen, daß bei Nenn-Kollektor-Emitter-Spannung U_{CEN} der Kurzschluß-Kollektorstrom I_{CK} einen Wert von 400 A erreicht. Gemäß dem Diagramm liegt dieser Betriebspunkt I_{CK}, U_{CEN} außerhalb des schraffierten Bereichs. Dies bedeutet, daß der Schalttransistor 2 zerstört wird, wenn als Ausräumstrom der negative Basisstrom I_{B1} vorgesehen wird. Zumindest führt diese "harte Ausräumung" des Schalttransistors 2 zu Einschnüreffekten, wodurch der Transistor seine Abschaltfähigkeit verliert. Wenn man nun anstelle des negativen Basisstromes I_{B1} den negativen Basisstrom I_{B2} bzw. einen negativen Basisstrom, dessen Wert kleiner ist als der Wert des negativen Basisstromes I_{B2}, so könnte der Schalttransistor 2 ausgeschaltet werden bei maximaler Ausnutzung seiner Kurzschlußfestigkeit. Die Sperrung der Stromquellen 14 und 16 und die Aktivierung der Stromquelle 18 erfolgt durch das Steuerglied 24, sobald von der einen oder anderen Überwachung 6 oder 8 ein Signal geliefert wird. Somit erhält man eine Schutzschaltung für einen Schalttransistors 2, dessen Kurzschlußfestigkeit im Nenn- und Kurzschlußbetrieb maximal ausgenutzt werden kann.

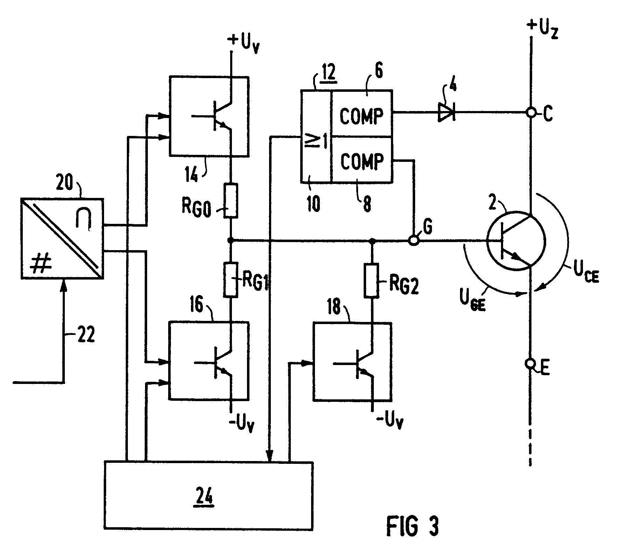

Die FIG 3 zeigt ein schematisiertes Grundschaltbild der erfindungsgemßen Schutzschaltung. Dabei ist ein IGBT-Transistor 2 kollektorseitig an eine Versorgungsspannung +U_{Z} angeschlossen. Dieser IGBT-Transistor 2 kann einer der beiden Schalttransistoren eines Brückenzweigs eines Stromrichters sein, wobei der Emitter E dann mit einem Kollektor des zweiten Schalttransistors des Brückenzweigs verbunden ist. Aus Übersichtlichkeitsgründen ist der zweite Schalttransistor des Brückenzweigs bzw. der Stromrichter, bestehend aus mehreren Brückenzweigen nicht dargestellt. Als Versorgungsspannungsquelle +U_{Z} kann auch ein den Stromrichter speisender Zwischenkreis vorgesehen sein.

Wenn der IGBT-Transistor 2 einer von beispielsweisen sechs Schalttransistoren eines Stromrichters ist, kann eine Last, die aus Übersichtlichkeitsgründen nicht dargestellt ist, am Kollektor C bzw. am Emitter E des IGBT-Transistors 2 angeschlossen sein. Über eine Entkopplungsdiode 4 ist eine Kollektor-Emitter-Überwachung 6 mit dem Kollektor C des IGBT-Transistors 2 verbunden, seine Gate G, d.h. sein Steuereingang, ist direkt mit einer Gate-Emitter-Überwachung 8 verknüpft. Ausgangsseitig ist die Kollektor-Emitter-Überwachung 6 an die Gate-Emitter-Überwachung 8 mittels eines ODER-Gliedes 10 verbunden. Diese beiden Überwachungen 6 und 8 und das ODER-Gliedes 10 bilden zusammen eine Baueinheit 12 als Laststromüberwachungsschaltung. An das Gate G des IBGT-Transistors 2 ist außerdem noch über einen Widerstand R_{G0} und eine Schaltstufe 14 eine positive Spannung +Uᵥ bzw. über einen Widerstand R_{G1} und eine Schaltstufe 16 oder einen Widerstand R_{G2} und eine Schaltstufe 18 eine negative Spannung -Uᵥ anschaltbar.

Die positive und die negative Spannungsversorgung über die für den regulären Schaltbetrieb wirksamen Schaltstufen 14 und 16 werden von einem potentialtrennenden Wandler 20 aktiviert. Für diesen ist ein Digital-Analog-Wandler mit Potentialtrennung vorgesehen. Diesem Wandler 20 wird ein Steuersignal mittels einer Leitung 22 aus einer Drehzahl-Regelung bzw. einer übergeordneten Steuerung zugeführt, wobei die Drehzahl-Regelung bzw. die übergeordnete Steuerung aus Übersichtlichkeitsgründen nicht dargestellt ist.

Die Schaltstufen 14, 16 und 18 sind mit einem Steuerglied 24 verknüpft. Diesem Steuerglied 24 wird das Ausgangssignal des ODER-Glieds 10 der Baueinheit 12 zugeführt. Wenn jedoch der IGBT-Transistor 2 entweder nur mit der Kollektor-Emitter-Überwachung 6 oder nur mit der Gate-Emitter-Überwachung 8 versehen wäre, so wäre jeweils der Ausgang der Überwachung 6 bzw. 8 direkt mit dem Eingang des Steuerglieds 24 verknüpft. Das Steuerglied 24 ist nun so, beispielsweise als eine logische Schalteinrichtung ausgebildet, daß die im Überlastfall, beispielsweise bei Kurzschluß, die Schaltstufen 14 und 16 gesperrt werden und die Schaltstufe 18 freigegeben wird.

Dabei sind die Widerstände R_{G1} und R_{G2} so ausgelegt, daß die Abschaltgeschwindigkeit des IGBT-Transistors 2 im Überlastfall gegenüber der regulären Abschaltgeschwindigkeit reduziert wird. Dazu ist der Widerstand R_{G2} größer gewählt als der Widerstand R_{G1}.

Denkbar wäre es allerdings auch, daß für den Widerstand R_{G1} ein variabler Widerstand gewählt würde, der je nach Belastung des IGBT-Transistors 2 in Stufen oder kontinuierlich in seinem Widerstandswert erhöht würde. Auf den zweiten Widerstand R_{G2} könnte dann verzichtet werden. Die zwei Pfade zum Abschalten sind dabei baulich zusammengefaßt.

## Patentansprüche

1. Schaltung zum Einschalten eines Schalttransistors (2) über einen ersten Signalpfad für das jeweilige Einschaltsignal von vorgegebener Stromstärke und zum Ausschalten des Schalttransistors (2) im Normalbetrieb über einen zweiten Signalpfad für ein jeweils vorgegebenes Abschaltsignal von vorgegebener Stromstärke und im Überlastfall über einen dritten Signalpfad für ein Überlast-Abschaltsignal von gegenüber dem Normalbetrieb reduzierter Stromstärke, wobei eine erste Überwachungseinrichtung (6) die Kollektor-Emitter-Spannung auf das Überschreiten eines für den Normalbetrieb vorgegebenen Spannungswertes überwacht und bei dessen Überschreiten jeweils ein erstes Überlastsignal an ein Steuerglied (24) leitet, das dann die Weiterleitung des Einschaltsignals und des Ausschaltsignals für den Normalbetrieb sperrt und das Überlast-Abschaltsignal freigibt, **dadurch gekennzeichnet,** daß der zweite und der dritte Signalpfad zu einem einzigen Pfad vereinigt sind, in den ein variabler Widerstand (R_{G1}) geschaltet ist, dessen Widerstandswert im Überlastfall bis zum für den Überlastfall erforderlichen Wert erhöht wird, daß ferner eine zweite Überwachungseinrichtung (8) für die Basis-Emitter-Spannung vorgesehen ist, die bei Überschreiten eines für den Normalbetrieb vorgegebenen Spannungswertes ein zweites Überlastsignal erzeugt und daß das erste und das zweite Überlastsignal über ein ODER-Glied (10) gleichwirkend an das Steuerglied (24) gelangen.

2. Schaltung nach Anspruch 1, **dadurch gekennzeichnet,** daß als Schalttransistor ein IGBT-Transistor (2) verwendet wird, wobei dann an Stelle der Basis-Emitter-Überwachung eine Gate-Emitter-Überwachung tritt.

3. Schaltung nach Anspruch 1 oder 2, **dadurch gekennzeichnet,** daß eingangsseitig ein potentialtrennender Ansteuerwandler (20) vorgesehen ist.

## Claims

1. Circuit for switching on a switching transistor (2) via a first signal path for the respective switching-on signal of predetermined current intensity and for switching-off the switching transistor (2) in normal operation via a second signal path for a respectively predetermined switching-off signal of predetermined current intensity, and in the case of overload via a third signal path for an overload-switching-off signal of current intensity reduced with respect to normal operation, wherein a first monitoring device (6) monitors the collector-emitter-voltage until it exceeds a voltage value predetermined for normal operation and when this is exceeded, respectively conveys a first overload signal to a control element (24) which then blocks the further conveying of the switching-on signal and of the switching-off signal for normal operation and releases the overload-switching-off signal, characterised in that the second and the third signal paths are combined to form a single path into which a variable resistance (R_{G1}) is connected, the resistance value of which is increased in the case of overload to the value necessary for overload, in that a second monitoring device (8) for the base-emitter-voltage is also provided and, when a voltage value predetermined for normal operation is exceeded, produces a second overload signal, and in that the first and the second overload signal reach the control element (24) via an OR-gate (10) and have the same effect.

2. Circuit according to claim 1, characterised in that an IGBT transistor (2) is used as a switching transistor, and instead of base-emitter monitoring there is gate-emitter monitoring.

3. Circuit according to claim 1 or 2, characterised in that a potential-dividing control transformer (20) is provided on the input side.

## Revendications

1. Circuit pour placer à l'état conducteur un transistor de commutation (2) par l'intermédiaire d'une première voie de transmission pour le signal de mise à l'état conducteur, qui possède une intensité de courant prédéterminée, et pour placer à l'état bloqué le transistor de commutation (2) dans le fonctionnement normal, par l'intermédiaire d'une seconde voie de transmission pour un signal prédéterminé de mise à l'état bloqué, qui possède une intensité de courant prédéterminée, et dans le cas d'une surcharge, par l'intermédiaire d'une troisième voie de transmission pour un signal de mise à l'état bloqué en cas de surcharge, qui possède une intensité de courant réduite par rapport au fonctionnement normal, et dans lequel un premier dispositif de contrôle (6) contrôle la tension collecteur-émetteur pour déterminer si elle dépasse une valeur de tension prédéterminée pour le fonctionnement normal et, dans le cas où cette valeur de tension est dépassée, applique un premier signal de surcharge à un circuit de commande (24), qui bloque alors la retransmission du signal de mise à l'état conducteur et du signal de mise à l'état bloqué pour le fonctionnement normal et libère le signal de débranchement en cas de surcharge, caractérisé par le fait que les seconde et troisième voies de transmission de signaux sont réunies pour former une seule voie de transmission, dans laquelle est branchée une résistance variable (R_{G1}), dont la valeur résistive est accrue, dans le cas d'une surcharge, jusqu'à la valeur nécessaire pour le cas d'une surcharge, qu'en outre il est prévu un second dispositif de contrôle (8) pour la tension base-émetteur, qui, dans le cas du dépassement d'une valeur de tension prédéterminée pour le fonctionnement normal, produit un second signal de surcharge et que le premier et second signal de surcharge parviennent, par l'intermédiaire d'un circuit OU (10), et avec un effet équivalent, au circuit de commande (24).

2. Circuit suivant la revendication 1, caractérisé par le fait qu'on utilise comme transistor de commutation un transistor IGBT (2), auquel cas à la place du contrôle base-émetteur, on exécute un contrôle grille-émetteur.

3. Circuit suivant la revendication 1 ou 2, caractérisé par le fait qu'il est prévu, coté entrée, un transducteur de commande (20) qui réalise une séparation de potentiel.
